# EUROPEAN PATENT APPLICATION

(11) **EP 1 564 814 A2**
(43) Date of publication of application: **17.08.2005**
(21) Application number: 05010368.8
(22) Date of filing: 30.12.2002
(51) Int. Cl.: H01L 27/15, H01L 51/20

(54) **Organic light emitting display**

(30) Priority: 28.12.2001 JP 2001400996
(62) Divisional of application: 02259009.5
(71) Applicant: Sanyo Electric Co., Ltd., Moriguchi-shi, Osaka (JP)
(72) Inventor: Inoue, Kazuhiro, Motosu-Gun Gifu (JP); Koma, Norio, Motosu-Gun Gifu (JP); Ogawa, Shinji, Ohgaki-Shi Gifu (JP); Yamashita, Tohru, Anpachi-Gun Gifu (JP); Oda, Nobuhiko, Hashima-Shi Gifu (JP); Ishida, Satoshi, Ohgaki-Shi Gifu (JP); Yamada, Tsutomu, Hozumi-Cho Motusu-Gun Gifu (JP)
(74) Representative: Cross, Rupert Edward Blount

(57) **Abstract**

A display apparatus comprising a substrate on which an electroluminescence element having an organic element layer between a first electrode and a second electrode; a switching element which is provided for each pixel between the substrate and the first electrode; an insulating film which is formed on the switching element; and a reflective layer which is formed on the insulating film and insulated from the switching element, the reflective layer reflecting light entering from a side near the organic element layer; wherein the first electrode is formed by a transparent conductive material directly covering the reflective layer and is electrically connected with the switching element.

## Description

### BACKGROUND OF THE INVENTION

### Field of the Invention

The present invention relates to a reflective or transflective display apparatus or the like having a reflective function.

### Description of Related Art

Liquid crystal display apparatuses (hereinafter referred to as "LCDs") are advantageous in that they are thin and consume relatively little power, and have been widely used for computer monitors and monitors for portable information devices or the like. In LCDs, liquid crystal is sealed between a pair of substrates each having an electrode formed thereon, and the orientation of the liquid crystal disposed between these electrodes is controlled by these electrodes to thereby achieve display. Contrary to CRT (Cathode Ray Tube) displays, electroluminescence (hereinafter referred to as "EL") displays or the like, LCDs require a light source in order to display an image for viewer observation, because LCDs are not, in principle, self-emissive.

Transmissive LCDs, in which a transparent electrode is used as an electrode formed on each substrate and a light source is disposed on the rear or side of the LC panel, can provide bright display even in a dark environment, by controlling the transmission amount of light from the light source through the LC panel. Transmissive LCDs, however, have disadvantages in that power consumption is relatively high due to the light source which must continually illuminate, and that sufficient contrast cannot be ensured when the display is used in a bright environment, such as outdoors under daylight.

In reflective LCDs, on the other hand, external light such as sunlight and room light is used as a light source, and such an ambient light entering the LCD panel is reflected by a reflective electrode formed on the substrate provided on the non-viewing surface side. Thus, light enters through the liquid crystal layer, is reflected by the reflective electrode, and then exits from the LCD panel. By controlling the amount of light radiating from the LCD panel for each pixel, reflective LCDs display an image. While reflective LCDs, which use external light as a light source, differ from LCDs in that their display is dark or black when no such external light is available, they have advantages that power consumption is very low because the power required for the light source can be eliminated and that sufficient contrast can be obtained in the bright environment such as outdoors. Conventional reflective LCDs, however, have been inferior to transmissive LCDs with regard to general display qualities such as color reproductivity and display brightness.

On the other hand, with an increasing demand for reduced power consumption of a device, reflective LCDs, which are more advantageous than transmissive LCDs with respect to power consumption, have been tested for application as highly resolution monitors of portable devices and studied and developed for quality improvement.

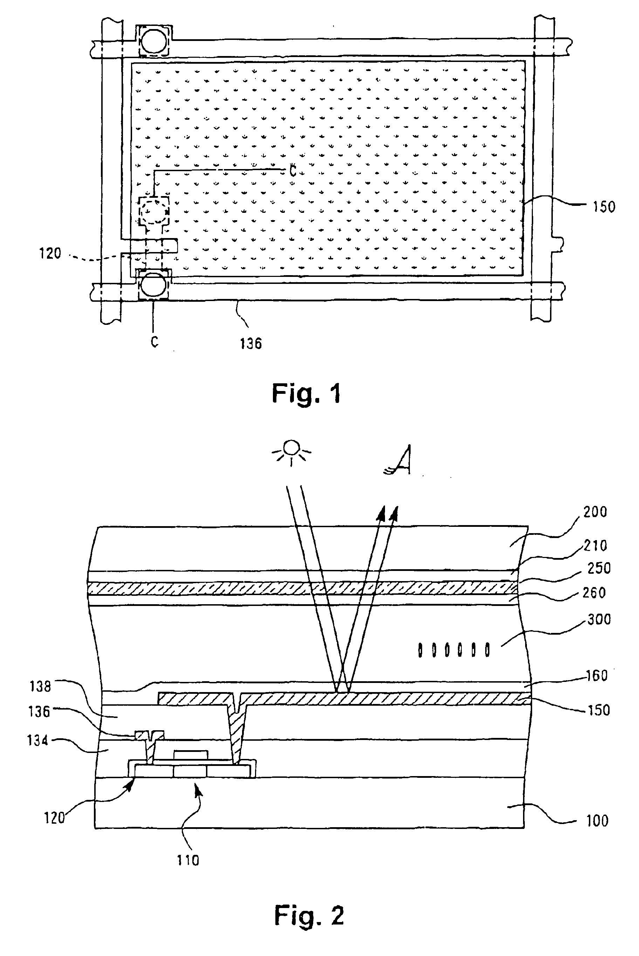

Fig. 1 is a plan view showing one pixel portion of a conventional active matrix reflective LCD in which a thin film transistor (TFT) is provided for each pixel. Fig. 2 schematically shows a cross sectional configuration of the reflective LCD taken along line C-C of Fig. 1.

The reflective LCD comprises a first substrate 100 and a second substrate 200 which are adhered to each other with a predetermined gap therebetween and a liquid crystal layer 300 sealed between the first and second substrates. A glass or plastic substrate is used for the first and second substrate 100 and 200, while a transparent substrate is used as the second substrate 200 located on the viewer side, at least in this example.

On the side facing the liquid crystal layer of the first substrate 100, a thin film transistor (TFT) 110 is formed for each pixel. In this TFT 110, for example, a drain region in an active layer 120 is connected with a data line 136 which supplies a data signal to each pixel via a contact hole formed in an inter-layer insulating film 134. A source region of the TFT 110 is connected with a first electrode (pixel electrode) 150 which is individually formed for each pixel via a contact hole formed to penetrate the inter-layer insulating film 134 and a planarization insulating film 138.

A material having a reflective function, such as Al, Ag, or the like, is employed as the first electrode 150. On the reflective electrode 150, an alignment film 160 is formed so as to control the initial alignment of the liquid crystal layer 300.

When the LCD is a color LCD, on the side facing the liquid crystal layer of the second substrate 200, which is disposed so as to oppose to the first substrate 100, a color filter (R, G, B) 210 is formed, and a transparent electrode 250 comprising a transparent conductive material such as ITO (Indium Tin Oxide) is formed on the color filter 210. Further, on the transparent electrode 250, an alignment film 260 which is similar to the alignment film 160 on the first substrate side is formed.

In the reflective LCD configured as described above, the amount of light which enters the liquid crystal panel, is reflected by the reflective electrode 150, and radiates from the liquid crystal panel, is controlled for each pixel, to thereby produce a desired display.

In LCDs, not limited to the reflective LCD, the liquid crystal is driven by an alternating voltage so as to prevent image persistence. With regard to transmissive LCDs, as both the first electrode on the first substrate and the second electrode on the second substrate should be transparent, ITO is used as a material for both electrodes. Consequently, for AC driving of the liquid crystal, each of the first and second electrodes can apply a positive or negative voltage on substantially the same conditions.

However, in the reflective LCD as shown in Fig. 2, in which a reflective electrode formed by a metal material is used as the first electrode 150 and a transparent electrode formed by a transparent metal oxidation material such as ITO is used as the second electrode 250, certain problems such as display flicker and image persistence in the liquid crystal layer may occur depending on the drive conditions. These problems are noticeable when the liquid crystal is driven at a frequency less than the critical flicker frequency (CFF), for example, which has been reported recently. In order to further reduce power consumption of LCDs, attempts have been made to reduce the frequency for driving the liquid crystal (the frequency for writing data to liquid crystal capacitor at each pixel formed in the region where the first and second electrodes face each other) equal or less than the CFF at which image flicker can be recognized by a human eye, approximately 40Hz - 30Hz, by reducing such a drive frequency to less than 60Hz which is a reference frequency in the NTSC standard, for example. It has been revealed, however, that when each pixel of a conventional reflective liquid crystal panel is driven at less than the CFF, the above-described problems of flicker and image persistence in the liquid crystal layer are significant, which leads to significant deterioration in display quality.

The applicant's research for the causes of such flicker and image persistence in the liquid crystal layer generated in a reflective LCD as shown in Figs. 1 and 2 revealed that asymmetricity of the electrical characteristics of the first and second electrodes relative to the liquid crystal layer 300 is one cause. It is believed that such asymmetricity results from a significant difference between a work function of 4.7eV ~ 5.2eV for the transparent metal oxide such as ITO used in the second electrode 250 and a work function of 4.2eV - 4.3eV for the metal such as Al used in the first electrode 150. Such a difference in the work function would cause there to be a difference of a charge actually induced on the liquid crystal interface via the alignment films 160 and 260, when the same voltage is applied to each electrode. Such a difference of charge induced on the interface between the liquid crystal and the alignment layer at each electrode side would then cause impurity ions or the like to be unevenly located toward only one electrode within the liquid crystal layer, which results in accumulation of remaining DC voltage in the liquid crystal layer 300. As the liquid crystal drive frequency is lowered, the influence of this remaining DC voltage on the liquid crystal increases and generation of flicker and image persistence in the liquid crystal layer becomes more significant. Accordingly, driving the liquid crystal at a frequency not greater than the CFF, in particular, is substantially difficult.

Reflective LCDs in which ITO is used for both the first and second electrodes as in transmissive LCDs and a reflector is separately provided on the outer side of the first electrode (on the side of the first electrode not facing the liquid crystal) are conventionally known. When a reflector is thus provided on the outer side of the fist substrate, however, the length of a light path is increased by an amount corresponding to the thickness of the transparent first electrode 150 and of the transparent first substrate, thereby making the display quality likely to deteriorate due to parallax. Consequently, in reflective LCDs which demand high display quality, a reflective electrode is employed as a pixel electrode, and it is therefore impossible to reduce the drive frequency so as to achieve lower power consumption, because flicker or the like is generated at the lower drive frequency, as described above.

### SUMMARY OF THE INVENTION

The present invention was conceived in view of the aforementioned problems of the related art and achieves a display apparatus free from effect of flicker and parallax and having a reflective function which provides high display quality and relatively low power consumption, in which electrical properties of the first and second electrodes are equal.

In accordance with an aspect of the present invention there is provided a display apparatus according to the accompanying claims.

### BRIEF DESCRIPTION OF THE DRAWINGS

These and other advantages of the invention will be explained in the description below, in connection with the accompanying drawings, in which:
Fig. 1 is a view showing a plan configuration of a section of a conventional active matrix reflective LCD on the first substrate side;
Fig. 2 is a view schematically showing a cross sectional configuration of the conventional reflective LCD taken along line C-C of Fig. 1;
Fig. 3A is a view schematically showing a plan configuration of an active matrix reflective LCD;
Fig. 3B is a view schematically showing a cross sectional configuration of the reflective LCD taken along line A-A of Fig. 3A;
Fig. 4A is a view schematically showing another cross sectional configuration of the reflective LCD taken along line A-A of Fig. 3A;
Fig. 4B is a view schematically showing another cross sectional configuration of the reflective LCD taken along line A-A of Fig. 3A;
Fig. 5A is a view schematically showing a plan configuration of an active matrix transflective LCD;
Fig. 5B is a view schematically showing a cross sectional configuration of the transflective LCD taken along line B-B of Fig. 5A; and
Fig. 6 is a view schematically showing a cross sectional configuration of an active matrix organic EL display of the present invention.

### DETAILED DESCRIPTION OF THE PREFERRED EMBODIMENT

A preferred embodiment of the present invention, hereinafter referred to simply as the embodiment, will be described with reference to the drawings.

A display apparatus having a first substrate having a first electrode, a second substrate having a second electrode, and a liquid crystal layer sealed between the first substrate and the second substrate for performing display, wherein the first substrate further includes a switching element provided for each pixel, and a reflective layer which is formed on an insulating film covering the switching element so as to be insulated from the switching element, the reflective layer reflecting light entering the liquid crystal layer through the second substrate, and wherein the first electrode is formed by a transparent conductive material so as to directly cover the reflective layer and is electrically connected with the switching element.

As described above, on the first substrate side, the transparent first electrode having a property similar to that of the second electrode on the second substrate is formed toward the liquid crystal, and the reflective layer is formed on the insulating films such as the inter-layer insulating film and the planarization insulating film and under the first electrode such that the reflective layer is insulated from the switching element of each pixel, so that the liquid crystal layer can be driven by the first and second electrodes with symmetry. In particular, the apparatus of the present invention can achieve high quality display without generating flicker or the like, even when the drive frequency for the liquid crystal layer in each pixel is set lower than, for example, 60Hz.

In a display apparatus as described above, a connection metal layer is formed within a contact hole formed in the insulating film covering the switching element, and the switching element and the first electrode are electrically connected via the connection metal layer.

In a display apparatus as described above, the connection metal layer includes a refractory metal material, at least on a surface contacting the first electrode.

In a display apparatus as described above, a difference between a work function of the transparent conductive material of the first electrode and a work function of a transparent conductive material formed on a side of the second substrate toward the liquid crystal layer is 0.5 eV or less.

A method of manufacturing a display apparatus including a first substrate having a first electrode, a second substrate having a second electrode, and a liquid crystal layer sealed between the first substrate and the second substrate, the method comprising the steps of forming a thin film transistor on the first substrate side; forming an insulating film formed from at least one layer so as to cover the thin film transistor; forming a contact hole in a region of the insulating film corresponding to an active layer of the thin film transistor; forming a connection metal layer in the region of the contact hole; forming a reflective material layer so as to cover the insulating film and the connection metal layer and patterning the reflective material layer so that the reflective material layer remains in a predetermined pixel region other than a region above the connection metal layer, to form a reflective layer; and forming the first electrode from a transparent conductive material so as to cover the reflective layer and the connection metal layer and electrically connecting the first electrode to the thin film transistor via the connection metal layer.

Thus, in a configuration in which the first electrode is disposed toward the liquid crystal, by interposing the connection metal layer between the first electrode and the thin film transistor, it is possible to prevent deterioration of the electrodes and active layer of the thin film transistor when patterning the reflective layer under the first electrode. Consequently, the first electrode formed on the reflective layer can be reliably connected with the thin film transistor.

On a first substrate, a TFT which is a switching element is provided for each pixel, and above an insulating film covering this TFT, a reflective layer which is insulated from the TFT and which reflects light entering a second substrate and transmitting through a second electrode made of ITO is formed. Further, a first electrode having a work function similar to that of the second electrode and made of a transparent conductive material such as ITO is formed closer to a liquid crystal layer than the reflective layer, and this first electrode is connected with the TFT. With this configuration, the liquid crystal layer can be symmetrically AC driven by the first and second electrodes. A reliable connection between the first electrode and the TFT is provided through a connection metal layer made of a refractory metal.

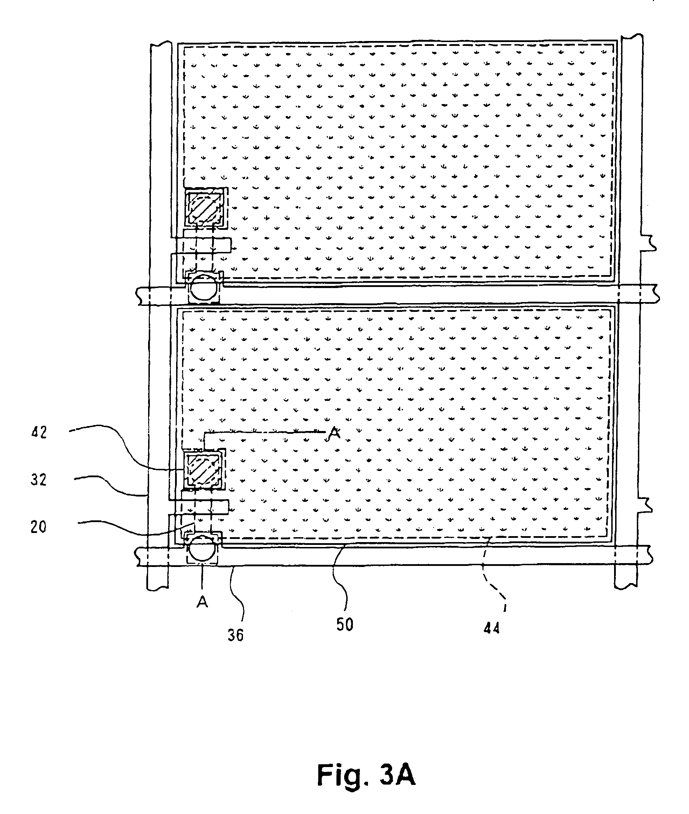

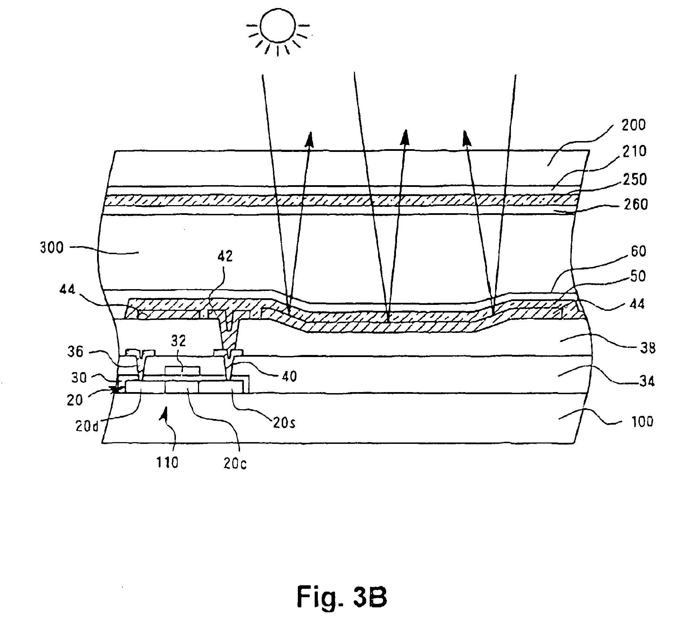

Fig. 3A is a plan view showing a partial configuration on the first substrate side of a reflective active matrix LCD which is an example reflective LCD according to the embodiment of the present invention. Fig. 3B is a schematic sectional view of the LCD taken along line A-A of Fig. 3A. In an active matrix LCD, a plurality of pixels are provided in a matrix within the display region and a switching element such as a TFT is provided for each pixel. The switching element is formed for each pixel on one of first and second substrate side, such as on the side of the first substrate 100, and is connected with a pixel electrode (first electrode) 50 which is formed in individually pattern.

A transparent substrate such as glass is used for the first and second substrate 100 and 200. When the LCD is a color LCD, a color filter 210 is formed on the side of the second substrate 200 facing the first substrate 100, as in the conventional LCD. On the color filter 210, a second electrode 250 made of a transparent conductive material such as IZO (Indium Zinc Oxide) or ITO is formed. In an active matrix LCD, the second electrode 250 is formed as a common electrode for all pixels. Further, on the second electrode 250, an alignment film 260 made of polyimide or the like is formed.

According to the present embodiment, the apparatus on the second substrate side configured as described above employs an electrode structure whose electrical property is similar to that of an electrode on the first substrate with regard to the liquid crystal layer 300. More specifically, as shown in Fig. 3B, the first electrode 50 which is made of a material having a work function similar to that of the second electrode 250, that is, a transparent conductive material as used in the second electrode 250 such as IZO and ITO, and not a reflective metal electrode as conventionally employed, is formed immediately under an alignment film 60 on the first substrate 100. Then, in order to create a reflective LCD, a reflective layer 44 which reflects incident light entering through the second substrate 200 is formed under the first electrode 50.

By forming the first electrode 50 of the same material as used for the second electrode 250, electrodes having the same work function sandwich the liquid crystal layer 300, via the alignment layers 60 and 260, respectively, so that the liquid crystal layer 300 can be AC driven by the first and second electrodes 50 and 250 with very good symmetry. Here, the work functions of the first and second electrodes 50 and 250 need not be completely identical and may be as approximate to each other as possible so that the liquid crystal layer 300 can be symmetrically driven. When the difference between the work functions of the both electrodes is approximately 0.5eV or less, high quality display without flicker or image persistence in the liquid crystal layer can be achieved, even when the drive frequency for the liquid crystal is set to CFF or lower, as described above.

In order to satisfy the above conditions for the electrodes, for example, IZO (whose work function is 4.7eV ~ 5.2eV) can be used for the first electrode 50 and ITO (whose work function is 4.7eV ~ 5.0eV) can be used for the second electrode 250, or vice versa. The material used for each electrode may be selected in consideration of process properties such as transmissivity and patterning precision and manufacturing cost.

With regard to the reflective layer 44, a material with good reflective property, such as Al, Ag, and alloys thereof (Al-Nd alloy is used in the present embodiment), is used at least on the top surface side (on the surface side toward the liquid crystal layer). While the reflective layer 44 may be a single layer made of a metal material such as Al, a layer made of a refractory metal (high melting point metal) such as Mo may be additionally provided as a lower buffer layer which contacts a planarization insulating film 38. With such a lower buffer layer, the adhesiveness between the reflective layer 44 and the planarization insulating film 38 can be enhanced to thereby improve the reliability of the device. In the configuration shown in Fig. 3B, the planarization insulating film 38 includes, within each pixel region, a slant surface formed at a desired angle, and the reflective layer 44 which is formed so as to cover the planarization insulating film 38 also has a similar slant portion on the surface. By forming such a slant surface at an optical angle and location, it is possible to collect and radiate outside light for each pixel, and therefore the display brightness at the front position of the display can be increased, for example. It should be understood, however, that such a slant surface need not necessarily be provided.

The reflective layer 44, which is made of a conductive material such as Al, as described above, is electrically insulated from the first electrode 50 formed on the reflective layer 44 because the first electrode 50 is formed by sputtering IZO or ITO, when these materials are used. More specifically, because the reflective layer 44 made of Al, when exposed to the sputtering atmosphere, undergoes oxidation reaction on its surface and is covered with a natural oxide film. Therefore, according to the present embodiment, rather than using this reflective layer 44 as a first electrode which drives the liquid crystal as in the convention reflective LCD, the transparent conductive layer formed on the reflective film 44 is used as the first electrode 50 for applying a voltage in accordance with the display data to the liquid crystal 300.

In recent years, so-called transflective LCDs having both light transmission function and reflective function have been proposed. For such a transflective LCD, a configuration is known in which a pixel electrode such as ITO is first formed and a reflective electrode such as Al is then formed to cover a portion of the transparent electrode, as in the transmissive LCD. In a transflective LCD configured such that the transparent electrode layer and the reflective electrode layer are sequentially disposed in this order from the substrate side, these two electrode layers are electrically connected and function as a single pixel electrode. However, because, in this single pixel electrode, the reflective electrode is located toward the liquid crystal layer, due to the difference of work functions between this reflective electrode and the second electrode, the liquid crystal layer 300 cannot be symmetrically driven. While disposing the electrode layers in the reverse order in order to form a single pixel electrode so as to improve the symmetry in electrical properties may be considered, this approach does not solve the above problem. Specifically, as described above, a natural oxide film is likely to be formed on the surface of a metal material such as Al and Ag used for the reflective electrode. In particular, when such a metal layer which is formed undergoes sputtering for forming the transparent conductive material layer thereon, the metal layer is covered with a natural oxide film and is insulated from the transparent electrode. Consequently, even if the order of the electrodes is reversed, the liquid crystal cannot be driven by the transparent electrode on the first substrate side, and it is impossible to match the electrically properties of the first and second substrate sides with regard to the liquid crystal.

According to the present embodiment, on the other hand, while the reflective layer 44 is insulated from both the first electrode 50 and the TFT 110, the first electrode 50 and the TFT 110 can be reliably connected because a connection metal layer 42 is interposed between the first electrode 50 and the TFT 110 (for example, a source electrode 40 of the TFT 110). Further, on the first substrate, the liquid crystal can be driven by the first electrode 50 made of a transparent conductive material and disposed adjacent to the liquid crystal layer, as in the second substrate.

Here, the following conditions, for example, are required for the above-mentioned metal layer 42 employed in the present embodiment for connecting the first electrode 50 and the TFT 110:
(i) the metal layer 42 should be electrically connected with the first electrode 50 made of IZO, ITO, or the like;
(ii) the metal layer 42 should be electrically connected with the source electrode 40 when the source electrode 40 made of Al, for example, is provided in the TFT 110 as shown in Fig. 3B and should be electrically connected with a semiconductor (poly-silicon) active layer when the source electrode 40 is omitted; and
(iii) the metal layer 42 should not be removed by an etchant used for patterning the reflective layer individually for each pixel.

It is preferable that a refractory metal material such as Mo, Ti, and Cr is used for the metal layer 42.

A configuration for accomplishing reliable connection between the first electrode 50 and the corresponding TFT 110 as provided by the present embodiment and a manufacturing method of achieving this configuration will be described.

A top gate type TFT is employed as the TFT 110 and polycrystalline silicon (p-Si) obtained by poly-crystallization of amorphous silicon (a-Si) by laser annealing is used for the active layer 20. Of course, the TFT 110 is not limited to a top gate type p-Si and may be a bottom gate type, and a-Si may be used for the active layer. While either n or p conductivity type impurities may be doped in the source and drain regions 20s and 20d of the active layer 20 in the TFT 110, in the present embodiment, an n conductivity type impurity such as phosphorus is doped to form a n-ch TFT 110.

The active layer 20 of the TFT 110 is covered with a gate insulating film 30, and a gate electrode 32 which is made of Cr or the like and also functions as a gate line is formed on the gate insulating film 30. After formation of the gate electrode 32, the above-mentioned impurities are doped in the active layer 20 using the gate electrode 32 as a mask to form the source and drain regions 20s and 20d and also form a channel region 20c in which no impurities are doped. Then, an inter-layer insulating film 34 is formed so as to cover the whole TFT 110. After contact holes are formed in the inter-layer insulating film 34, electrode materials are formed, so that the source electrode 40 and the drain electrode 36 are connected with the source and drain regions 20s and 20d of the p-Si active layer 20, respectively. In the present embodiment, the drain electrode 36 also functions as a data line for supplying a data signal in accordance with the display data to each TFT 110. The source electrode 40, on the other hand, is connected with the first electrode 50 which is a pixel electrode, as will be described below.

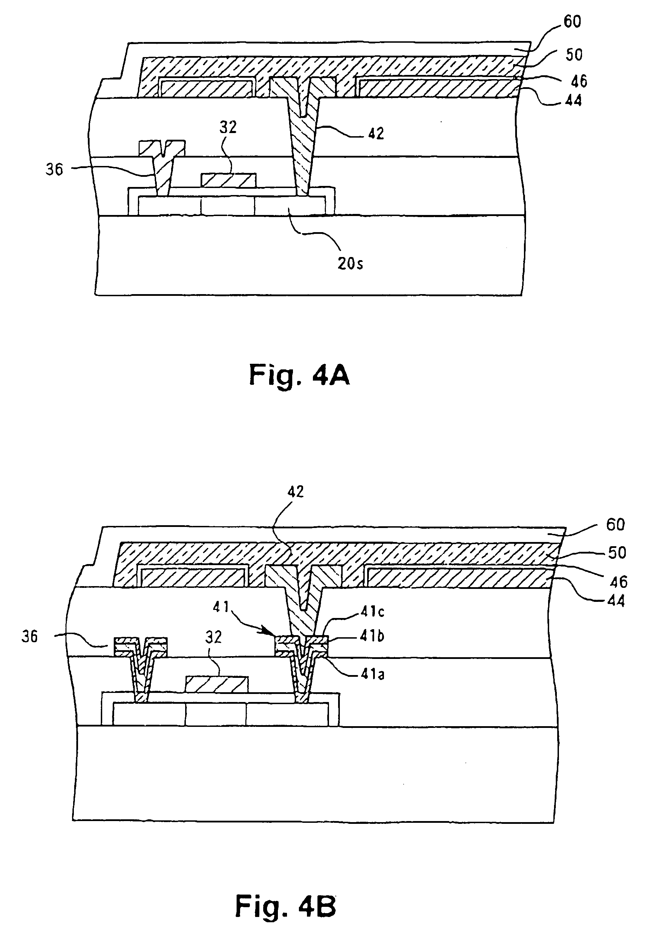

After formation of the source electrode 40 and the drain electrode 36, the planarization insulation film 38 made of a resin material such as acrylic resin is formed so as to cover the whole surface of the substrate. A contact hole is then formed in a portion of the planarization insulating film 38 corresponding to the source electrode 40, and the connection metal layer 42 is formed in this contact hole so that the source electrode 40 and the metal layer 42 are connected. By employing a metal material such as Mo for the metal layer 42 when Al or the like is used for the source electrode 40, a good ohmic contact can be achieved between the metal layer 42 and the source electrode 40. It should be noted that the source electrode 40 can be eliminated as shown in Fig. 4A. In such a case, although the metal layer 42 contacts the silicon active layer 20 of the TFT 110, a metal such as Mo can also establish an ohmic contact with such a semiconductor material.

After disposing and patterning the connection metal layer 42, a material with superior reflective property such as an Al-Nd alloy and Al for forming the reflective layer 44, is disposed on the whole surface of the substrate by evaporation or sputtering. The reflective material thus disposed is removed by etching so that none remains around the source region of the TFT (where the metal layer 42 is formed) in such a manner that the reflective material does not disturb contact between the metal layer 42 and the first electrode 50 subsequently formed. Thus, the reflective layer 44 which is pattered as shown in Fig. 3A is formed in each pixel. According to the present embodiment, in order to prevent the TFT 110 (particularly the channel region 20c thereof) from being irradiated with light to generate a leak current and in order to increase the region in which reflection can be achieved (namely, the display region) to the fullest extent possible, the reflective layer 44 is actively formed over the channel region of the TFT 110, as shown in Fig. 3B.

With regard to the patterning of the reflective layer 44 as described above, the metal layer 42 made of Mo or the like has a sufficient thickness (0.2 m, for example) and sufficient resistance to an etchant. Accordingly, even after the reflective layer 44 on the metal layer 42 is etched for removal, the metal layer 42 is not removed and can completely remain within the contact hole. Further, in the absence of the metal layer 42, the source electrode 40, which is often formed by the same material (such as A1) as used for the reflective layer 44, would undergo corrosion by the etchant used for the reflective layer 44, thereby causing disconnection or the like. Therefore, according to the present embodiment, the metal layer 42 is provided so as to resist the patterning of the reflective layer 44, so that preferable electrical connection can be maintained between the reflective layer 44 and the source electrode 40.

After the reflective layer 44 is patterned, a transparent conductive layer is disposed by sputtering so as to cover the whole substrate including the reflective layer 44. At this time, while the surface of the reflective layer 44 made of Al or the like is covered with an insulative natural oxide film (see numeral 46 in Fig. 4A) as described above, a refractory metal such as Mo does not undergo surface oxidation even when exposed to the sputtering atmosphere. Therefore, the metal layer 42 exposed in the contact region can make ohmic contact with the transparent conductive layer for the first electrode which is disposed on the metal layer 42. After formation, the transparent conductive layer is further patterned in an individual form for each pixel as shown in Fig. 3A, thereby forming the pixel electrode 50 (the first electrode). Further, after the first electrode 50 is formed in each pixel region, the alignment film 60 made of polyimide or the like is formed so as to cover the whole substrate to complete the device on the first substrate side. Then, the second substrate 200 on which various layers are formed up to the alignment film 260 and the first substrate 100 are adhered to each other at the peripheral portions of the substrates with a predetermined gap therebetween, and liquid crystal is sealed between these substrates to complete a liquid crystal display apparatus.

As shown in Fig. 4B, the metal layer 42 of the present embodiment can also maintain preferable connection with the source electrode 41 when the source electrode 41 has a multi-layered configuration in which an Al layer is interposed between refractory metal layers such as Mo. More specifically, the source electrode 41 (also the drain electrode 37 which also functions as the data line) shown in Fig. 4B is formed by sequentially disposing a Mo layer 41a, an Al layer 41b, and a Mo layer 41c in this order from the active layer side. Because the Mo layer 41a is formed toward the active layer 20 made of p-Si, it is possible to prevent Si atoms from moving into the Al layer 41b, causing a defect in the active layer. Further, because the Mo layer 41c is formed as the top layer, it is possible to maintain preferable electrical connection between the metal layer 42 and the source electrode even through contact formation and formation and etching of the metal layer 42. According to the present embodiment, because the metal layer 42 is made of Mo or the like which is also used for the top layer of the source electrode 41, good contact is also established between the metal layer 42 and the source electrode 41 shown in Fig. 4B.

Further, the metal layer 42 of the present embodiment may have a multi-layered configuration as in the source electrode 41 shown in Fig. 4B. The multi-layered configuration may be, for example, a three-layered configuration including, from the bottom, a refractory metal layer such as Mo, a conductive layer such as Al, and a refractory metal layer such as Mo, or a two-layered configuration including, from the bottom, a conductive layer such as Al and a refractory metal layer such as Mo. When such a multi-layered metal layer 42 is employed, the source electrode 40 disposed under the metal layer 42 may have the above-mentioned multi-layered configuration as shown in Fig. 4B or a single-layer configuration such as Al. Further, when the metal layer 43 is in direct contact with the active layer 20 as shown in Fig. 4A, the metal layer 43 may employ the three-layer or two-layered configuration as described above. In order to maintain electrical connectivity after formation of an insulating film on the surface when the first electrode 50 is formed, it is necessary that the metal layers 42 and 43 be able to resist etching and remain stable. It is preferable that a refractory metal layer is formed at least on the surface of the metal layer 42 or 43 which contacts the first electrode 50.

Transflective LCDs will next be described. In the above example, a reflective LCD in which the reflective layer 44 is formed on substantially the whole region within one pixel region has been described. The present invention is, however, also applicable to a transflective LCD in addition to such a reflective LCD.

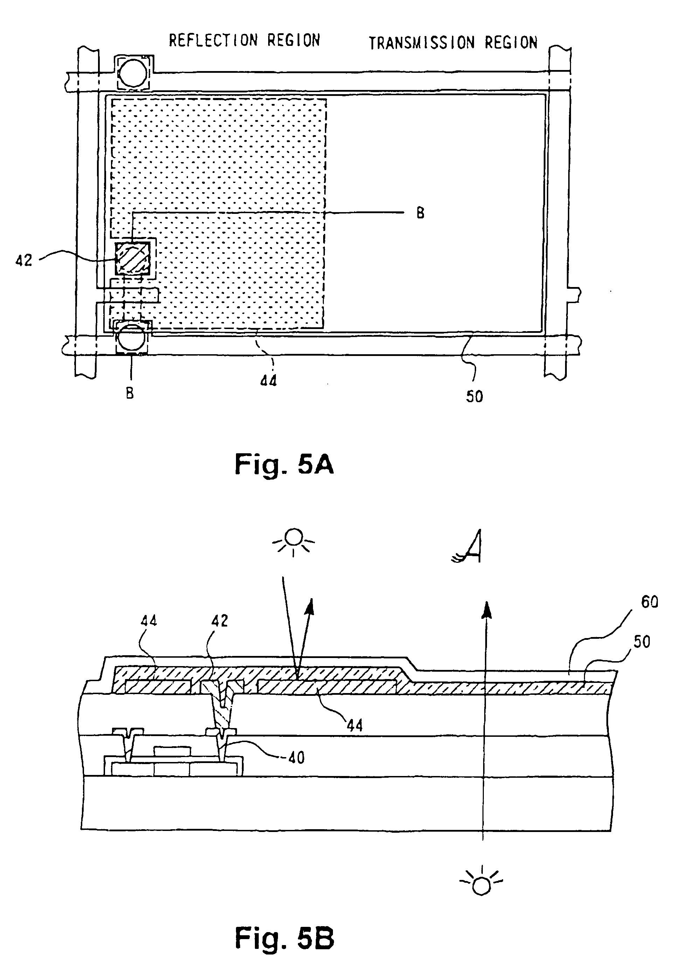

Fig. 5A shows a plan configuration of a transflective active matrix LCD corresponding to one pixel, and Fig. 5B is a cross sectional view schematically showing the LCD taken along line B-B of Fig. 5A. In the reflective LCD shown in Figs. 3A and 3B, the reflective layer 44 is formed in substantially the region of one pixel (except the TFT region and the contact region). In the transflective LCD as shown in Figs. 5A and 5B, on the other hand, a reflective region in which a reflective layer 44 and a transparent first electrode 50 are disposed in a laminate form and a light transmissive region in which the reflective layer 44 is eliminated and only the transparent first electrode 50 is disposed are formed within one pixel.

In such a transflective LCD, the first electrode 50 is similarly disposed closer to the liquid crystal layer than the reflective layer 44 and the reflective layer 44 is insulated from the first electrode 50 formed immediately above the reflective layer 44 by the natural oxide film 46. Further, the reflective layer 44 is removed from the contact region between the TFT 110 region and the first electrode 50 so as not to interrupt contact therebetween. Accordingly, it is similarly possible for the liquid crystal layer 300 to be symmetrically driven by the first electrode 50 and the second electrode 250 having similar work functions via the respective alignment films. It is further possible to switch the light source in accordance with the intensity of ambient light or the like to achieve either reflection or transmission display.

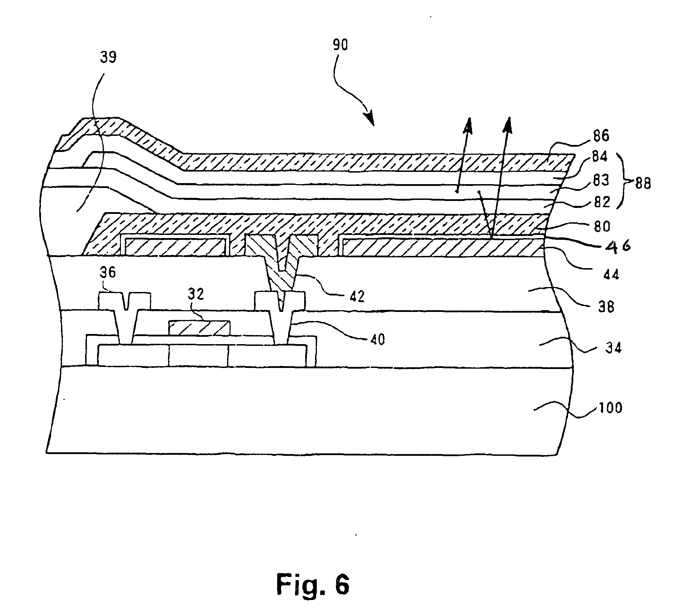

While a reflective or transflective LCD having a reflective layer 44 has been described, when the configuration of the switching element (TFT), the connection metal layer, the reflective layer, and the transparent first electrode of the present invention is applied to an EL display apparatus, it is possible to dispose the reflective function under the transparent first electrode while the first electrode can be reliably connected with the TFT located under the first electrode. Fig. 6 shows a partial sectional configuration of each pixel of an active matrix EL display according to the present embodiment.

The EL display shown in Fig. 6 employs an organic EL element 90 using an organic compound as an emissive material, which comprises an anode 80, a cathode 86, and an organic element layer 88 interposed therebetween. The organic element layer 88 includes at least an emissive layer 83 containing an organic emission functional molecule and may have a single layer configuration or a multi-layered configuration formed of two, three, or more layers, in accordance with the characteristics and emission color or the like of an organic compound. In the example shown in Fig. 6, the organic element layer 88 comprises a hole transport layer 82, an emissive layer 83, and an electron transport layer 84 sequentially formed, in that order, from the side of the anode 80 disposed toward the substrate 100. The emissive layer 83 is individually patterned similar to the anode 80, and the hole transport layer 82 and the electron transport layer 84 are formed as an electrode which is common to all pixels similar to the cathode 86. The anodes 80 of adjacent pixels are insulated from each other, and a planarization insulating film 39 is formed between the anodes of adjacent pixels in order to prevent a short circuit between the anode 80 and the cathode 86 formed thereabove in the edge region of the anode 80.

In the organic EL element 90 configured as described above, holes injected from the anode 80 and electrons injected from the cathode 86 are recombined within the emissive layer 83 to excite organic emissive molecules. When these organic emissive molecules are returned to the ground state, the organic EL element 90 emits light. In the organic EL element, which is thus a driven-by-current type emissive element, the anode 80 must have a sufficient hole injection ability with regard to the organic element layer 88 and is therefore often formed by a transparent conductive material having a high work function, such as ITO and IZO. Therefore, in many cases, light from the emissive layer 83 transmits and radiates outside from the transparent substrate 100 through the anode 80. In the active matrix organic EL display shown in Fig. 6, however, it is possible to cause light to radiate from the cathode, as will be described below.

In a display such as that shown in Fig. 6, the TFT 110 for driving the organic El element 90, the metal layer 42, the reflective layer 44, and the anode 80 of the organic El element 90 have configurations similar to the above-described TFT 110, the metal layer 42, the reflective layer 44, and the first electrode 50, respectively, shown in Fig. 3B, for example. Therefore, when a transparent conductive material is used for the anode 80, the reflective layer 44 formed from a material with good reflective property such as Al and Al-Nd alloy and insulated from the anode 80 can be provided under the anode 80. Consequently, by forming the cathode 86 of the organic EL element 90 using a transparent conductive material such as ITO and IZO as in the anode 80 or using a metal material such as Al and Ag which is thin enough to transmit light (such a metal layer may have an opening), a top emission configuration in which light from the emissive layer 83 is radiated out from the cathode 86 can easily be implemented. More specifically, as shown in Fig. 6, light from the emissive layer 83 passes through the anode 80 and is reflected by the reflective layer 44 disposed under the anode 80, which makes it possible to eventually radiate light from the emissive layer 83 through the cathode 86.

As described above, according to the embodiment of the present invention, even when a reflective layer must be formed on one of substrate of a display, as in a reflective or transflective LCD, first and second electrodes having similar properties can be disposed symmetrically with regard to the liquid crystal layer, and the liquid crystal can therefore be symmetrically driven using an AC current. As a result, high quality display can be achieved without generation of flicker or image persistence, even when the drive frequency for the liquid crystal is not greater than the CFF, for example.

While the preferred embodiment of the present invention has been described using specific terms, such description is for illustrative purposes only, and it is to be understood that changes and variations may be made.

## Claims

1. A display apparatus comprising:
a substrate (100) on which an electroluminescence element (90) having an organic element layer (88) between a first electrode (80) and a second electrode (86);
a switching element (110) which is provided for each pixel between the substrate (100) and the first electrode (80) ;
an insulating film (38) which is formed on the switching element (110); and
a reflective layer (44) which is formed on the insulating film (38) and insulated from the switching element (110), the reflective layer (44)reflecting light entering from a side near the organic element layer (88); wherein
the first electrode (80) is formed by a transparent conductive material directly covering the reflective layer (44) and is electrically connected with the switching element (110).

2. A display apparatus according to Claim 1, wherein
a connection metal layer (42) is formed in a contact hole formed through the insulating film (38) covering the switching element (110), and
the switching element (110) and the first electrode (80) are electrically connected via the connection metal layer (42).

3. A display apparatus according to Claim 2, wherein
a refractory metal material is used for the connection metal layer (42) at least at a contact surface with the first electrode (80).

4. A display apparatus according to any one of Claims 1 - 3, wherein
a transparent conductive material is used for the second electrode (86).

5. A display apparatus according to any one of Claims 1 - 4, wherein
a natural oxide film (46) is formed on a surface of the reflective layer covered by the first electrode.

6. A display apparatus according to any one of Claims 1 - 5, wherein
a contact hole is formed through the insulating film (38) formed covering the switching element (110);
a metal connection layer (42) is formed in the contact hole;
the switching element (110) and the first electrode (80) are electrically connected only via the connection metal layer (42); and
the reflective layer (44) is removed in a region in which the contact hole is formed and is insulated from the switching element and the first electrode.

7. A display apparatus according to any one of Claims 1 - 6, wherein
light emitted from the organic element layer (88) and reflected by the reflective layer (44) is emitted to the outside through the second electrode (86).

8. A display apparatus according to any one of Claims 1 - 7, wherein
the insulating layer (38) comprises an interlayer insulating film (34) formed covering the switching element and a planarizing insulating film (38) formed over the interlayer insulating film (34), and
the reflective film (44) is formed over the planarizing insulating film (38).
